(19) Europäisches Patentamt
European Patent Office
Office européen des brevets

(11) EP 0 850 324 B1

(12) EUROPEAN PATENT SPECIFICATION

(45) Date of publication and mention
of the grant of the patent:
07.11.2001 Bulletin 2001/45

(21) Application number: 96929637.5

(22) Date of filing: 30.08.1996

(51) Int Cl.⁷: $C23C\ 30/00$, C23C 16/30,
C23C 16/40, B23B 27/14

(86) International application number:
PCT/SE96/01076

(87) International publication number:
WO 97/09463 (13.03.1997 Gazette 1997/12)

(54) COATED TURNING INSERT

BESCHICHTETER DREHEINSATZ

PLAQUETTE DE TOURNAGE REVETUE

(84) Designated Contracting States:
AT CH DE FR GB IT LI SE

(30) Priority: 01.09.1995 SE 9503056

(43) Date of publication of application:
01.07.1998 Bulletin 1998/27

(73) Proprietor: SANDVIK AKTIEBOLAG
811 81 Sandviken (SE)

(72) Inventors:
• LJUNGBERG, Björn
S-122 44 Enskede (SE)
• AKESSON, Leif
S-125 51 Älvsjö (SE)

(74) Representative: Östlund, Alf Olof Anders et al
Sandvik AB Central Service
Patents and Licences
811 81 Sandviken (SE)

(56) References cited:
EP-A- 0 408 535         EP-A- 0 594 875
EP-A- 0 653 499         EP-A- 0 685 572
EP-A- 0 709 484         US-A- 4 610 931

• PATENT ABSTRACTS OF JAPAN, Vol. 18, No.
392, C-1228; & JP,A,06 108 254, (MITSUBISHI
MATERIALS CORP), 19 April 1994.
• PATENT ABSTRACTS OF JAPAN, Vol. 18, No.
203, M-1590; & JP,A,06 008 008, (MITSUBISHI
MATERIALS CORP), 18 January 1994.
• DIALOG INFORMATION SERVICE, File 351,
World Patent Index 81-94, Dialog Accession No.
009992182, WPI Accession No. 94-259893/32,
(MITV) MITSUBISHI MATERIALS CORP,
"Surface Coated Cutting Tool - Has Composite
Hard Layer Comprising Inner Layer of Carbide,
Nitride, Carbonitride, Oxycarbide and/or
Carbonitrooxide of Titanium"; & JP,A,06 190 605,
12-07-94, (9432), Basic.

EP 0 850 324 B1

**Description**

The present invention relates to a coated cutting tool (cemented carbide insert) particularly useful for difficult cutting conditions such as turning in hot and cold forged low alloyed steel components like gear rings and axles used in the automotive industry and turning in stainless steel components like bars, tubes and flanges.

Stainless and low alloyed steels are materials which, in general, are difficult to machine with coated or uncoated cemented carbide tools. Smearing of work piece material onto the cutting edge and flaking of the coating often occur. The cutting conditions are particularly difficult during the turning of forged low alloyed components under wet conditions (using coolant). The hot forged skin (0.05-0.2 mm) is generally decarburized and thus softer than the bulk material due to a mainly ferritic structure. The cold forged skin (less than 0.05 mm) is cold-worked and, thus, harder due to a deformation hardening effect. Furthermore, the ferrite/pearlite bulk structure of such a material is often "ferrite-striated", i. e. the ferrite and pearlite are forming parallel stripes. This mixture of hard and soft materials makes the cutting conditions very difficult.

Further, when turning stainless and low alloyed steels by coated cemented carbide tools the cutting edge is worn by chemical wear, abrasive wear and by a so called adhesive wear. The adhesive wear is often the tool life limiting wear. Adhesive wear occurs when fragments or individual grains of the layers and later also parts of the cemented carbide are successively pulled away from the cutting edge as work piece chips are formed. Further, when wet turning is employed the wear may also be accelerated by an additional wear mechanism. Coolant and work piece material may penetrate into the cooling cracks of the coatings. This penetration often leads to a chemical reaction between work piece material and coolant with the cemented carbide. The Co-binder phase may oxidise in a zone near the crack and along the interface between the coating and the cemented carbide. After some time coating fragments are lost piece by piece.

Swedish patent application 9501286-0 discloses a coated cutting insert particularly useful for dry milling of grey cast iron. The insert is characterised by a straight WC-Co cemented carbide body and a coating including a layer of $TiC_xN_yO_z$ with columnar grains and a top layer of fine grained $\alpha$-$Al_2O_3$.

Swedish patent application 9502640-7 discloses a coated turning insert particularly useful for intermittent turning in low alloyed steel. The insert is characterised by a WC-Co cemented carbide body having a highly W-alloyed Co-binder phase and a coating including a layer of $TiC_xN_yO_z$ with columnar grains and a top layer of a finegrained, textured $\alpha$-$Al_2O_3$.

EP-A-685572 discloses a coated hard alloy blade member which includes a substrate formed of a hard alloy of a WC-based cemented carbide or a TiCN-based cermet, and a hard coating deposited on the substrate. The hard coating includes an inner layer of TiCN having unilaterally grown crystals of an elongated shape and an outer layer of $Al_2O_3$ having a crystal form kappa or $\kappa + \alpha$ wherein $\kappa > \alpha$.

EP-A-709484 discloses a surface-coated tungsten carbide-based cemented carbide blade member including a tungsten carbide-based cemented carbide substrate, and a hard coating of an average layer thickness of 3 to 30 $\mu$m formed thereon. The hard coating includes a first layer deposited on the substrate, a second layer deposited on the first layer, and a third layer deposited on the second layer. The first layer has a granular crystal structure, while the second layer has an elongated crystal structure. Among the constituents forming the substrate, at least tungsten and cobalt are diffused into the grain boundaries of the first and second layers.

EP-A-408535 discloses that improved properties of aluminum oxide wear layers on cemented carbides and related substrates can be obtained by combining the two alumina polymorphs ($\alpha$-$Al_2O_3$ and $\kappa$-$Al_2O_3$) as multilayers. The nucleation of $\alpha$-$Al_2O_3$ and $\kappa$-$Al_2O_3$ can be controlled by means of modification layers. According to this invention, it is thus possible to CVD-deposit an oxide multicoating layer consisting of clearly specified layers of $\alpha$-$Al_2O_3$ and $\kappa$-$Al_2O_3$.

EP-A-594875 concerns a tungsten carbide base cutting tools formed on sintered hard alloy substrate material. Multiple hard coatings are deposited on the Co-enriched surface layers of the substrate material, and a maximum value of the Co concentration in a layer occurs within a distance of 50 $\mu$m of the external surface of the substrate material, and this surface layer region is referred to as the denuded zone because the surface region is substantially free of carbides, carbonitrides and nitrides of Ti, Ta, and Nb containing W. The multilayer coating consists of a primary coating of TiCN, a secondary coating of $Al_2O_3$ and the surface coating consisting of at least one of TiCN and TiN. The interface between the substrate material and the primary coating is provided with a first intermediate coating consisting of TiN. The interface between the primary coating and the secondary coating is provided with a second intermediate coating consisting of at least one of TiC, TiCO and TiCON.

EP-A-686707 relates to a cutting tool whose surface is coated with a composite hard layer formed by means of chemical vapor deposition and having excellent wear resistance and chipping resistance. A cutting tool consists substantially of a substrate whose surface is coated with a composite hard layer consisting substantially of an inner layer including one or more layers of titanium carbide, titanium nitride, titanium carbonitride, titanium carboxide, and titanium oxicarbonitride, and an outer layer including at least one alumina layer.

JP-A-6-108254 relates to a cutting tool showing excellent cutting performance. A titanium nitride internal layer having 5 to 50nm thickness and whose crystalline grains have a granular structure is formed on the surface of a WC-base sintered hard alloy substrate. On the titanium nitride internal layer, a titanium carbo-nitride external layer having 1 to 8 $\mu$m thickness and whose crystalline grains have a columnar structure is formed. On the surface of the cutting tool made of the surface coated WC-base sintered hard alloy, furthermore, a single layer or multilayers of one or two kinds among aluminum oxide, titanium carbonate and titanium carbo-nitride-oxide having a 0.1 to 2 $\mu$m thickness.

It has surprisingly been found that by replacing the textured $\alpha$-$Al_2O_3$-layer of the above mentioned patent applications with a $\kappa$-$Al_2O_3$-layer a cutting tool with excellent properties for turning stainless and forged components in low alloyed steel can be obtained.

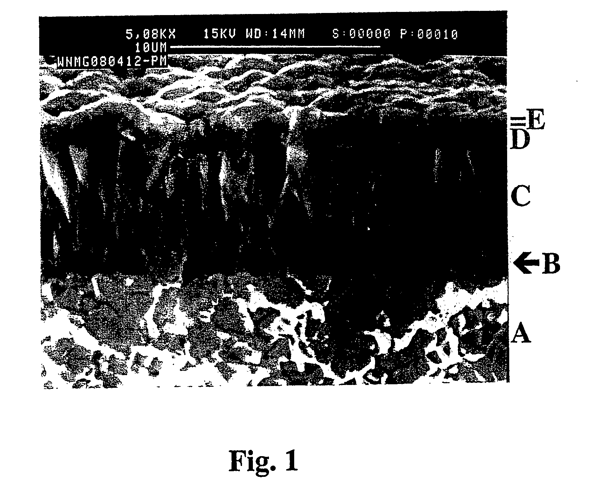

Fig 1 is a micrograph in 5000X magnification of a coated insert according to the present invention in which

> A - cemented carbide body
> B - $TiC_xN_yO_z$-layer with equiaxed grains
> C - $TiC_xN_yO_z$-layer with columnar grains
> D - $\kappa$-$Al_2O_3$-layer with columnar like grains
> E - TiN-layer (optional)

According to the present invention a turning tool insert is provided with a cemented carbide body of a composition 6.5-8, wt-% Co, 4-7.5, wt-% cubic carbides of the metals from groups IVb, Vb or VIb of the periodic table of elements preferably Ti, Ta and/or Nb and balance WC. The grain size of the WC is about 2 $\mu$m. The cobalt binder phase is highly alloyed with W. The content of W in the binder phase can be expressed as the

$$CW\text{-ratio}= M_s \,/(wt\text{-}\% \text{ Co} \cdot 0.0161),$$

> where $M_s$ is the measured saturation magnetization of the cemented carbide body in kA/m and
> wt-% Co is the weight percentage of Co in the cemented carbide. The CW-ratio is a function of the W content in the Co binder phase. A low CW-ratio corresponds to a high W-content in the binder phase.

It has now been found according to the invention that improved cutting performance is achieved if the cemented carbide body has a CW-ratio of 0.80-0.90. The cemented carbide body may contain small amounts, <1 volume-%, of $\eta$-phase ($M_6C$), without any detrimental effect. An about 15-35 $\mu$m thick surface zone depleted of cubic carbides and often enriched (generally more than 25 % enrichment) in binder phase can be present according to prior art such as disclosed in US 4,610,931. In this case the cemented carbide may contain carbonitride or even nitride.

The coating preferably comprises

- a first (innermost) layer of $TiC_xN_yO_z$ with x+y+z=1, and z<0.5, with a thickness of 0.1-2 $\mu$m and with equiaxed grains with size <0.5 $\mu$m
- a layer of $TiC_xN_y$ x+y=1, and x>0.3 and y>0.3, with a thickness of 5-8 $\mu$m, with columnar grains and with an average diameter of <5 $\mu$m,
- a layer of a smooth, fine-grained (grain size 0.5-2 $\mu$m) $Al_2O_3$ consisting essentially of the $\kappa$-phase. However, the layer may contain small amounts, 1-3 vol-%, of the $\theta$- or the $\alpha$-phases as determined by XRD-measurement. The $Al_2O_3$-layer has a thickness 1-3 $\mu$m a surface roughness $R_{max}\leq0.4$ $\mu$m over a length of 10 $\mu$m. This $Al_2O_3$-layer may be followed by further layers such as a thin (about 0.1-1 $\mu$m) decorative layer of e g TiN being removed along the cutting edge.

Example 1

A. Cemented carbide turning tool inserts of style CNMG 120408-PM with the composition 7.5 wt-% Co, 1.8 wt-% TiC, 0.5 wt-% TiN, 3.0 wt-% TaC, 0.4 wt-% NbC and balance WC, with a binder phase highly alloyed with W corresponding to a CW-ratio of 0.88 were coated with a 0.5 $\mu$m equiaxed TiCN-layer (with a high nitrogen content corresponding to an estimated C/N-ratio of 0.05) followed by a 7 $\mu$m thick TiCN-layer with columnar grains by using MTCVD-technique (temperature 885-850 °C and $CH_3CN$ as the carbon/nitrogen source). In subsequent steps during the same coating cycle, a 1.5 $\mu$m thick layer of $Al_2O_3$ was deposited using a temperature 970 °C and a concentration of $H_2S$ dopant of 0.4 % as disclosed in EP-A-523 021. A thin (0.5 $\mu$m) decorative layer of TiN was deposited on top according to known CVD-technique. XRD-measurement showed that the $Al_2O_3$-layer consisted of 100 % $\kappa$-phase. The cemented carbide body had a surface zone about 25 $\mu$m thick, depleted from cubic carbides and with an about 30 % enrichment in binder phase. The coated inserts were brushed by a nylon straw brush containing SiC grains. Examination of the brushed inserts in a light microscope showed that the thin TiN-layer had been brushed away only along the cutting edge leaving there a smooth, $R_a$=0.3 μm, $Al_2O_3$-layer surface. Coating thickness measurements on cross sectioned brushed samples showed no reduction of the coating along the edge line except for the outer TiN-layer that was removed.

B.) A strong competitive cemented carbide grade in style CNMG 120408 from an external leading carbide producer was selected for comparison in a turning test. The carbide had a composition of 9.8 wt-% Co, 0.2 wt-% TiC, 2.0 wt-% TaC, balance WC and a CW-ratio of 0.86. The insert had a coating consisting of a 5 μm TiCN-layer followed by a 1.5 μm thick $Al_2O_3$-layer and a 0.5 μm TiN-layer. Light microscope examination showed that the insert had not been smoothed along the edgeline after the coating step.

An insert from A was compared against an insert from B in a turning test in a hot forged ring gear (diameter 206 mm, in TSCM815H material). Each turning cycle performed on each component consisted of one facing cut, one longitudinal cut and one chamfering cut. The feed was 0.35 mm/rev and cutting speed around 230 m/min.

First, 150 components were machined with both insert A and B and obtained flank wear was measured and compared. Since the wear was much less developed on insert A it was allowed to cut further components, altogether 354 components. Obtained flank wear is shown in the table below:

|  | Number of components | measured flank wear, mm |
|---|---|---|
| insert A (according to the invention) | 150 | 0.07 |
| ------"--------- | 354 | 0.08 |
| insert B (external grade) | 150 | 0.10 |

Microscope examination of the tested inserts showed tiny flaking on insert B while no visible flaking had occurred on insert A, not even after 354 machined components.

It is obvious from the obtained flank wear that insert A according to the invention is superior and possesses longer tool life.

Example 2

D.) A strong competitive cemented carbide grade in style CNMG 120408 from another external leading carbide producer was selected for comparison in a turning test. The chemical composition of the cemented carbide was: 7.6 wt-% Co, 2.4 wt-% TiC, 0.5 wt-% TiN, 2.4 wt-% TaC, 0.3 wt-% NbC and balance WC. The cemented carbide had a surface zone, about 20 μm thick, depleted from cubic carbides. The composition of the cemented carbide was similar to that of the invention but had a higher CW-ratio of 0.93 and a different coating which consisted of a 5 μm TiCN-layer followed by a 3.5 μm TiC-layer, a 1.5 μm $Al_2O_3$-layer and a 0.5 μm TiN-layer. Light microscope examination showed that the insert had not been smoothed along the edgeline after the coating step.

Inserts from A and D were compared in a facing turning test in a hot forged ring gear (outer diameter of 180 mm and inner diameter of 98 mm in a SCr420H material) with feed = 0.25-0.35 mm/rev and cutting speed = 220 m/min. The inserts were run to a predetermined flank wear value of 0.08 mm and the number of produced component was the evaluation criteria.

|  | Number of components | measured flank wear, mm |
|---|---|---|
| insert A        edge 1(acc. to invent.) | 203 | 0.08 |
| ------"------- edge 2 | 226 | 0.08 |
| insert D (external grade) | 182 | 0.08 |

Example 3

C.) Cemented carbide turning tool inserts of style WNMG 080408-PM with the same composition and CW-ratio of 0.88 as insert A were coated according to A. XRD-measurement showed that the $Al_2O_3$-layer consisted of 100 % κ-phase. The inserts were brushed according to A.

E.) An insert in style WNMG 080408 from the same cemented carbide producer as in D and with the same CW-ratio, carbide composition and coating as in D was selected for comparison in a turning test. Light microscope examination showed that the insert had not been smoothed along the edgeline after the coating step.

Inserts from C and E were compared in a facing turning test of a forged axle (length of 487 mm and diameter of 27-65 mm, material 50CV4) with feed = 0.28-0.30 mm/rev and cutting speed = 160 m/min. Three axles were run per each cutting edge and the wear of the cutting edges was examined in a light microscope

insert C
(acc. to invent.)     flank wear less than 0.07 mm no flaking
insert E
(external grade)     flank wear less than 0.07 mm flaking and chipping along the edge

Example 4

F.) Cemented carbide turning tool inserts of style CNMG 120408-PM from the same batch as in A were coated according to Swedish patent application 9502640-7 corresponding to EP-A-0 753 603 with 0.5 equiaxed TiCN followed by a 7 μm thick layer TiCN with columnar grains, 1 μm equiaxed TiCN and a 4 μm thick 012-textured α-Al$_2$O$_3$. The inserts were wet-blasted using a water/Al$_2$O$_3$-slurry in order to smooth the coating surfaces.

G.) Cemented carbide turning tool inserts of style CNMG 120408-PM with the composition 6.5 wt-% Co and 8.8 wt-% cubic carbides (3.3 wt-% TiC, 3.4 wt-% TaC and 2.1 wt-% NbC) and balance WC were coated under the procedure given in A). The cemented carbide body had a CW-ratio = 1.0 and a surface zone about 23 μm thick depleted in cubic phase and enriched in binder phase. XRD-measurement showed that the Al$_2$O$_3$-layer consisted only of the κ-phase.

Inserts from A, F, G and B were compared in a turning test in a hot and cold forged ring gear in material SCr420H.

The ring had an outer diameter of 190 mm and an inner diameter of 98 mm. Each turning cycle performed on each component consisted of three facing cuts and one longitudinal cut. Feed = 0.25-0.40 mm/rev and cutting speed around 200 m/min. 170 components were machined and the wear of the cutting edges was examined.

insert A
(acc. to invent.)     no visible flaking of the coating, flank wear less than 0.07 mm

insert F
(CW-ratio = 0.88)     some removal of the coating along the cutting edge,
                    flank wear less than 0.08 mm

insert G
(CW-ratio = 1.0)     substantial flaking along the cutting edge and flank wear more than 0.10 mm

insert B
(external)     some removal of coating along the cutting edge,
                flank wear less than 0.08 mm

Although insert F produced according to EP-A-0 753 603 generally performs superior when turning low alloyed steels it can not always compete with insert A produced according to the present invention when turning some hot and cold forged low alloyed steel components.

**Claims**

1.   A cutting tool insert for turning in low alloyed steel comprising a cemented carbide body and a coating wherein said cemented carbide body consists of WC, 4-7.5 wt-% cubic carbides of Ti, Ta and/or Nb and 6.5-8 wt-% Co with a highly W-alloyed binder phase with a CW-ratio of 0.80-0.90 and a surface zone 15-35 μm thick depleted from cubic carbides and in that said coating consists of

   -   a first (innermost) layer of TiC$_x$N$_y$O$_z$ with x+y+z=1 and z<0.5 with a thickness of 0.1-2 μm, and with equiaxed grains with sizes of <0.5 μm
   -   a layer of TiC$_x$N$_y$ with x+y=1 and x>0.3 and y>0.3 with a thickness of 5-8 μm with columnar grains with a diameter of <5 μm
   -   an outer layer of a smooth, fine-grained kappa Al$_2$O$_3$-layer having a R$_{max}$≤0.4 μm over a length of 10 μm and a grain size of 0.5-2 μm, with a thickness of 1-3 μm.
   -   an outermost 0.1-1 μm TiN-layer being removed along the cutting edge.

**Patentansprüche**

1.  Schneidwerkzeugeinsatz zum Drehen in niedriglegiertem Stahl mit einem Hartmetallkörper und einem Überzug, wobei der Hartmetallkörper aus WC, 4 bis 7,5 Gew.% kubischen Carbiden von Ti, Ta und/oder Nb und 6,5 bis 8 Gew.% Co mit einer stark W-legierten Bindephase mit einem CW-Verhältnis von 0,80 bis 0,90 und einer Oberflächenzone von 15 bis 35 µm Dicke, die an kubischen Carbiden verarmt ist, besteht
und daß der Überzug aus

    -   einer ersten (innersten) Schicht von $TiC_xN_y$ mit x + y +z = 1 und z < 0,5 mit einer Dicke von 0,1 bis 2 µm und mit gleichachsigen Körnern mit Größen von <0,5 µm,

    -   einer $TiC_xN_y$-Schicht mit x + y = 1 und x >0,3 und y >0,3 mit einer Dicke von 5 bis 8 µm mit säulenartigen Körnern mit einem Durchmesser von <5 µm,

    -   einer äußeren Schicht aus einer glatten feinkörnigen kappa-$Al_2O_3$-Schicht mit einem $R_{max} \leq 0,4$ µm über eine Länge von 10 µm und einer Korngröße von 0,5 bis 0,5 bis 2 µm mit einer Dicke von 1 bis 3 µm

    -   und einer äußersten TiN-Schicht von 0,1 bis 1 µm, die zusammen mit der Schneidkante entfernt wird.

**Revendications**

1.  Plaquette d'outil de coupe pour le tournage dans de l'acier faiblement allié comprenant un corps de carbure cémenté et un revêtement dans lequel ledit corps de carbure cémenté se compose de WC, 4 à 7,5% en poids de carbures cubiques de Ti, Ta et/ou Nb et 6,5 à 8% en poids de Co avec une phase liante hautement alliée en W avec un rapport CW de 0,80 à 0,90 et une zone superficielle d'une épaisseur de 15 à 35 µm appauvrie en carbures cubiques, et en ce que ledit revêtement se compose:

    -   d'une première couche (la plus à l'intérieur) de $TiC_xN_yO_z$ avec x+y+z=1 et z<0,5 avec une épaisseur de 0,1 à 2 µm, et avec des grains équiaxiaux ayant des épaisseurs <0,5 µm;
    -   une couche de $TiC_xN_y$ avec x+y=1 et x>0,3 et y>0,3 avec une épaisseur de 5 à 8 µm avec des grains en forme de colonne ayant un diamètre <5 µm;
    -   une couche externe d'une couche de $Al_2O_3$ kappa, lisse, à grains fins, ayant un $R_{max} \leq 0,4$ µm sur une longueur de 10 µm et une taille de grain de 0,5 à 2 µm, avec une épaisseur de 1 à 3 µm;
    -   une couche TiN la plus à l'extérieur de 0,1 à 1 µm étant éliminée le long de l'arête tranchante.

**Fig. 1**